# EUROPEAN PATENT SPECIFICATION

(11) **EP 4 170 391 B1**
(45) Date of publication and mention of the grant of the patent: **05.11.2025**
(21) Application number: 22200509.2
(22) Date of filing: 10.10.2022
(51) Int. Cl.: G02B 1/00

(54) **RADIATIVE PASSIVE COOLING AND HEATING VIA METASURFACES AND NANOSTRUCTURED SURFACES**
PASSIVE STRAHLUNGSKÜHLUNG UND -ERWÄRMUNG ÜBER METAFLÄCHEN UND NANOSTRUKTURIERTE OBERFLÄCHEN
REFROIDISSEMENT PASSIF RADIATIF ET CHAUFFAGE PAR L'INTERMÉDIAIRE DE MÉTASURFACES ET DE SURFACES NANOSTRUCTURÉES

(30) Priority: 25.10.2021 US 202163271707 P; 04.03.2022 US 202217687590
(43) Date of publication of application: 26.04.2023
(73) Proprietor: Samsung Electronics Co., Ltd., Gyeonggi-do 16677 (KR)
(72) Inventor: SIDDIQUE, Radwanul, San Jose, CA 95134 (US)
(74) Representative: Kuhnen & Wacker Patent- und Rechtsanwaltsbüro PartG mbB

(56) References cited:
- KARTHIK RAMAN ET AL: "Fabrication of Refractive Index Tunable Polydimethylsiloxane Photonic Crystal for Biosensor Application", PHYSICS PROCEDIA, vol. 19, 11 August 2011 (2011-08-11), pages 146 - 151, XP028262360, ISSN: 1875-3892, [retrieved on 20110811], DOI: 10.1016/J.PHPRO.2011.06.139
- ZHAO BIN ET AL: "Radiative cooling: A review of fundamentals, materials, applications, and prospects", APPLIED ENERGY, vol. 236, 10 January 2018 (2018-01-10), pages 489 - 513, XP085582648, ISSN: 0306-2619, DOI: 10.1016/J.APENERGY.2018.12.018
- SONG JAEMAN ET AL: "Ultrahigh emissivity of grating-patterned PDMS film from 8 to 13 [mu]m wavelength regime", APPLIED PHYSICS LETTERS, AMERICAN INSTITUTE OF PHYSICS, 2 HUNTINGTON QUADRANGLE, MELVILLE, NY 11747, vol. 117, no. 9, 1 September 2020 (2020-09-01), XP012249757, ISSN: 0003-6951, [retrieved on 20200901], DOI: 10.1063/5.0017838

## Description

### TECHNICAL FIELD

The subject matter disclosed herein relates to metasurfaces and nanostructured surfaces. More particularly, the subject matter disclosed here relates to thermal-nanostructured metamaterials for thermal transparency of thermal optics and for passive cooling for electronic components.

KARTHIK RAMAN ET AL: "Fabrication of Refractive Index Tunable Polydimethylsiloxane Photonic Crystal for Biosensor Application", PHYSICS PROCEDIA, vol. 19, pages 146-151, XP028262360, relates to fabrication of refractive index tunable polydimethylsiloxane photonic crystal for biosensor application.

ZHAO BIN ET AL: "Radiative cooling: A review of fundamentals, materials, applications, and prospects", APPLIED ENERGY, vol. 236, pages 489-513, XP085582648, relates to radiative cooling.

SONG JAEMAN ET AL: "Ultrahigh emissivity of grating-patterned PDMS film from 8 to 13 [mu]m wavelength regime", APPLIED PHYSICS LETTERS, AMERICAN INSTITUTE OF PHYSICS, 2 HUNTINGTON QUADRANGLE, MELVILLE, NY 11747, vol. 117, no. 9, 1 September 2020 (2020-09-01), XP012249757, relates to an ultrahigh emissivity of grating-patterned PDMS film.

### SUMMARY

The invention is defined by the appended claims. An example embodiment provides a thermal-coating structure that includes a substrate having a top surface and a bottom surface, and nanostructures formed on and in contact with at least the top surface of the substrate in which the nanostructures include a refractive index of less than or equal to 1.75, and are substantially uniformly distributed across a predetermined area of at least the top surface of the substrate, and a number of the nanostructures further include a nominal aspect ratio of a structure height to a structure width greater than or equal to 1. Further, the nanostructures are formed from polydimethylsiloxane (PDMS), and a number of the nanostructures include nominal aspect ratios of between 4 and 6.

In an embodiment, the thermal-coating structure may include a transmissivity of greater than 80% for electromagnetic radiation having a wavelength range of 8000 nm to 12,000 nm inclusive. In still another embodiment, a number of the nanostructures comprise a nominal aspect ratio of 5. In yet another embodiment, the thermal-coating structure comprises a transmissivity of greater than 90% for electromagnetic radiation comprising a wavelength of 10,000 nm. In one embodiment, the thermal-coating structure may have a transmissivity of greater than 80% for electromagnetic radiation having a wavelength between 2000 nm and 14,000 nm inclusive. In the invention the nanostructures are formed from PDMS.

An example embodiment provides a non-contact temperature sensing device comprising the thermal-coating structure.

Throughout the specification, a "number of the nanostructures" may mean a substantial number of the nanostructures such as a majority of the nanostructures, i.e. more than half of the total number of nanostructures.

### BRIEF DESCRIPTION OF THE DRAWING

In the following section, the aspects of the subject matter disclosed herein will be described with reference to exemplary embodiments illustrated in the figure, in which:
FIG. 1A depicts an example embodiment of a thermal-nanostructured metamaterial 100 according to the subject matter disclosed herein;
FIG. 1B depicts another example embodiment of a thermal-nanostructured metamaterial according to the subject matter disclosed herein;
FIG. 2A shows six example depictions of nanostructures having aspect ratios between 1 and 10;
FIG. 2B depicts variations of nanostructures according to the subject matter disclosed herein when actually fabricated;
FIG. 3A shows a graph of example transmissivities for a thermal-nanostructured metamaterial formed from PDMS over electromagnetic wavelengths between 0.5 µm-17.5 µm (500 nm to 17500 nm) for ARs ranging from 1-10;
FIG. 3B depicts a non-contact thermal sensor device that uses a thermal-nanostructured metamaterial formed from PDMS as a thermal coating, or lens, according to the subject matter disclosed herein;
FIG. 4A depicts illustrative example not according to the invention of a nanostructure that may be formed from silicon nitride according to the subject matter disclosed herein;
FIGS. 4B and 4C respectively show graphs of transmissivity and reflectivity of nanostructures formed from silicon nitride and having aspect ratios between 0.14 and 0.86 over electromagnetic wavelengths between about 2.5 µm-17.5 µm according to the subject matter disclosed herein;
FIG. 4D is a graph showing peak emissivity for nanostructures formed from silicon nitride and having aspect ratios between about 0.1 and 2.0 according to the subject matter disclosed herein; and
FIG. 5 depicts an electronic device that may be configured to provide a non-contact thermal sensor that includes a thermal-nanostructured metamaterial configured to be a thermal coating, window, or lens, according to the subject matter disclosed herein.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "pre-determined," "pixel-specific," etc.) may be occasionally interchangeably used with a corresponding non-hyphenated version (e.g., "two dimensional," "predetermined," "pixel specific," etc.), and a capitalized entry (e.g., "Counter Clock," "Row Select," "PIXOUT," etc.) may be interchangeably used with a corresponding non-capitalized version (e.g., "counter clock," "row select," "pixout," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, the term "module" refers to any combination of software, firmware and/or hardware configured to provide the functionality described herein in connection with a module. For example, software may be embodied as a software package, code and/or instruction set or instructions, and the term "hardware," as used in any implementation described herein, may include, for example, singly or in any combination, an assembly, hardwired circuitry, programmable circuitry, state machine circuitry, and/or firmware that stores instructions executed by programmable circuitry. The modules may, collectively or individually, be embodied as circuitry that forms part of a larger system, for example, but not limited to, an integrated circuit (IC), system on-a-chip (SoC), an assembly, and so forth.

The subject matter disclosed herein provides thermal-nanostructured metamaterials for thermal transparency of thermal optics and passive cooling for electronic components. In one embodiment, nanostructures having aspect ratios (height/diameter) ≥ 1 may make materials or surfaces having a refractive index ≤ 1.75 substantially transparent to electromagnetic radiation in the infrared spectrum (wavelengths = 2-14 µm). In another embodiment, nanostructures having aspect ratios (height/diameter) ≥ 1 may make materials or surfaces having a refractive index ≥ 1.75 substantially emissive in the infrared spectrum (wavelengths = 2-14 µm) and may be used to assist in radiative cooling.

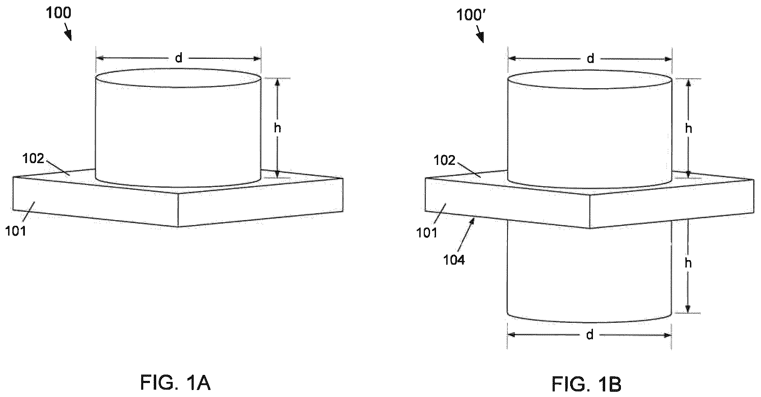

FIG. 1A depicts an example embodiment of a nanostructure 100 that is formed to be a thermal-nanostructured metamaterial according to the subject matter disclosed herein. Multiple nanostructures 100 may be formed on a substrate 101 so that the nanostructures are in contact with a top surface 102 of the substrate 101. FIG. 1A depicts a single nanostructure 100 that may be part of the multiple nanostructures or part of a group of multiple nanostructures. The aspect ratio (AR) (height h:diameter d) is greater than or equal to 1. The multiple nanostructures 100 are formed in a substantially uniform distribution over a predetermined area on the top surface 102 of the substrate 101. Some substantially negligible variations in the distribution may occur with no adverse impact on thermal properties of the thermal-nanostructured metamaterial 100.

Another example embodiment of a nanostructure 100' that is formed to be a thermal-nanostructured metamaterial is depicted in FIG. 1B. The single nanostructure 100' depicted in FIG. 1B may be part of multiple nanostructures or part of a group of multiple nanostructures. Multiple nanostructures 100' may be formed on a substrate 101 so that the nanostructures are in contact with a top surface 102 of the substrate 101. The aspect ratio (h:d) for the nanostructures 100' on both the top surface and the bottom surface of the substrate 101 is greater than or equal to 1. The multiple nanostructures 100' are formed in a substantially uniform distribution over corresponding predetermined areas on the top surface 102 and a bottom surface 104 of the substrate 101. Again, some substantially negligible variations in the distribution may occur with no adverse impact on thermal properties of the thermal-nanostructured metamaterial 100'. The performance of the double-sided thermal-nanostructured metamaterial 100' depicted in FIG. 1B is not substantially different from the single-sided thermal-nanostructured metamaterial 100 depicted in FIG. 1A.

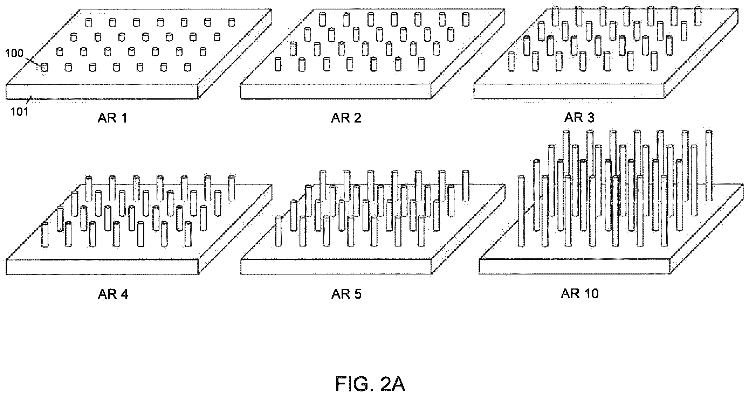

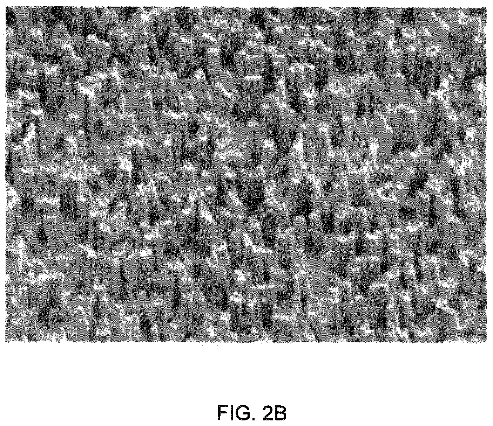

FIG. 2A shows six example depictions of nanostructures having aspect ratios between 1 and 10 In one embodiment, the example nanostructures in FIG. 2A may be nanostructures like nanostructure 100 in FIG. 1A. The nanostructures depicted in FIG. 2A may have diameters of (nominally) 50 nm. As depicted in FIG. 2A, the nanostructures are substantially uniformly distributed over the surface of a substrate, and the different heights of the nanostructures and corresponding ARs are indicated. The depictions in FIG. 2A are idealized. In actuality when the nanostructures are fabricated, the diameters, the heights and the uniformity of distribution of the nanostructures will have variations like the variations of nanostructures depicted in FIG. 2B that have a nominal aspect ratio of 3. As used herein, when a nominal diameter of a group of nanostructures is referred to, substantially greater than 40% of the group of nanostructures has a diameter that is equal to or greater than the nominal diameter. An average diameter of a group of nanostructures having a given nominal diameter is the about the nominal diameter. Similarly, as used herein, when a nominal aspect ratio of a group of nanostructures is referred to, substantially greater than 40% of the group of nanostructures has an aspect ratio that is equal to or greater than the nominal aspect ratio. An average aspect ratio of a group of nanostructures having a given nominal aspect ratio is about the nominal aspect ratio.

In the invention, the nanostructures 100 are formed from materials having a refractive index (i.e., the square root of the dielectric constant for the material) of less than or equal to 1.75 to form a thermal coating, window, or lens. Such a thermal coating may be used as a relatively low cost thermal optics for a non-contact thermal sensing device. An example material for this set of embodiments includes polydimethylsiloxane (PDMS). Polyolefin, polyethylene (high-density HDPE, low-density LDPE), AZ photoresist, Polypropylene, cross linked polypropylene, polycarbonate, and nylon are examples of materials not according to the invention.

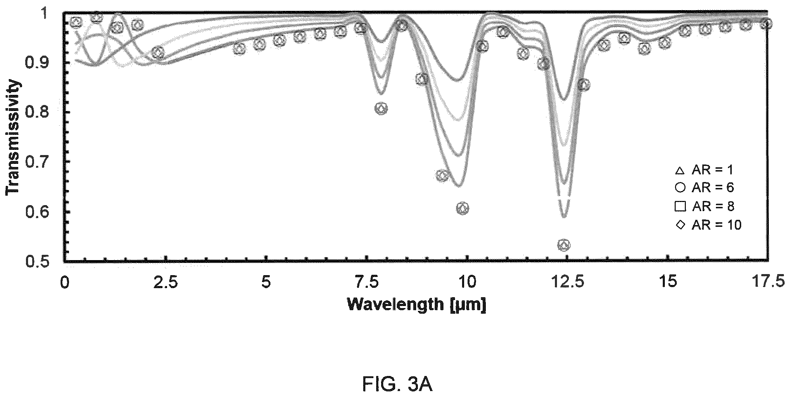

FIG. 3A shows a graph of example transmissivities for a thermal-nanostructured metamaterial formed from PDMS over electromagnetic wavelengths between 0.5 µm-17.5 µm (500 nm to 17500 nm) for ARs ranging from 1-10. The nominal diameter of the nanostructures was 100 nm. As can be seen in FIG. 3A, as the AR of the nanostructures increases from 1 to about 5, the transmissivity also increases. As the AR increases beyond about 5, the transmissivity begins to decrease. One example aspect shown in FIG. 3A for nanostructures formed from PDMS and having ARs between 4 and 6 is that the transmissivity is greater than 80% for electromagnetic radiation having a wavelength of 10,000 nm. When the AR of the nanostructures is 5, the transmissivity is greater than 90% for electromagnetic radiation comprising a wavelength of 10000 nm. Further, when the AR of the nanostructures is 5, the transmissivity is greater than 80% for electromagnetic radiation over a range of wavelengths between 2000 nm and 14000 nm inclusive.

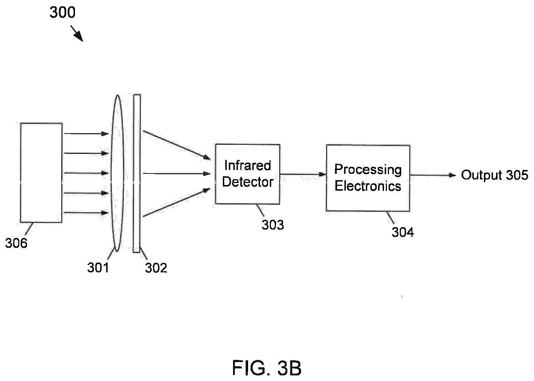

FIG. 3B depicts a non-contact thermal sensor device 300 that uses a thermal-nanostructured metamaterial formed from PDMS as a thermal optics, according to the subject matter disclosed herein. The non-contact thermal sensor 300 may include a focusing lens 301, an optional filter 302, an infrared detector 303, processing electronics 304, and an output 305. The focusing lens 301 collects and directs electromagnetic radiation emitted from an object 306 to the infrared detector 303. The focusing lens 301 may be a thermal-nanostructured metamaterial formed from PDMS and having characteristics similar to those described in connection with FIG. 3A. The optional filter 302 may be used to limit selected electromagnetic radiation wavelengths from being incident on the infrared detector 303. The infrared detector 303 detects incident infrared light and outputs a signal to the processing electronics 304 that corresponds to the incident electromagnetic radiation. The processing electronics 304 may include circuits and/or modules that convert the signal output from the infrared detect 303 to signal representing a temperature of an object 306.

In another set of illustrative examples not according to the invention, the nanostructures 303 may be formed from materials having a refractive index of greater than 1.75 to form a thermal-radiating structure. Such a thermal-radiating structure may be used to radiate heat from, for example, an integrated circuit. An example material for this set of embodiments includes silicon nitride (Si₃N₄), AlN, TiN, TiO₂, HfO₂, ZnO, and GaN. Depending on the application, the nanostructures 303 may be located, for example, on the top surface of an integrated circuit (IC) package or somewhere in the middle between the IC die and the top surface of the IC package, or a combination thereof to accelerate heat radiation and/or a cooling process.

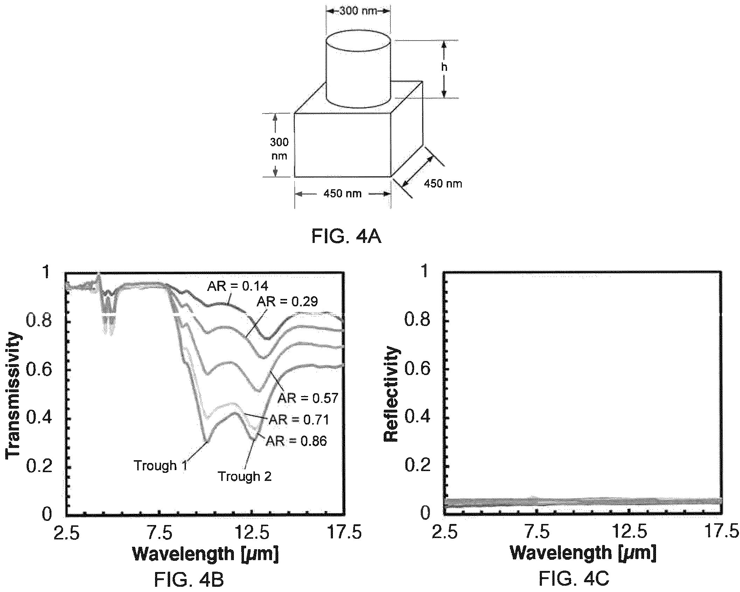

FIG. 4A depicts an illustrative example not according to the invention of a nanostructure 400 that may be formed from silicon nitride according to the subject matter disclosed herein. The nanostructure 400 provides a substantially emissive in the infrared spectrum (wavelengths = 2-14 µm) and may be used to assist in radiative cooling. The example nanostructure 400 is depicted as having an aspect ratio of 1, that is, the diameter equals the height h equals 300 nm. When formed from silicon nitride, the nanostructure 400 may have aspect ratios that are less than 1, equal to 1 and greater than 1.

FIGS. 4B and 4C respectively show graphs of transmissivity and reflectivity of nanostructures formed from silicon nitride and having aspect ratios between 0.14 and 0.86 over electromagnetic wavelengths between about 2.5 µm-17.5 µm (2500 nm to 17500 nm). As can be seen in FIG. 4B, as the AR of the nanostructures increases from 0.14 to about 0.9, the transmissivity decreases over the range of wavelengths. FIG. 4C also shows that the reflectivity remained near 0 for all ARs and did not substantially change over the range of wavelengths. The transmissivity graph of FIG. 4B shows two transmissivity troughs, Trough 1 and Trough 2. The reflectivity graph of FIG. 4C shows no significant peaks or troughs.

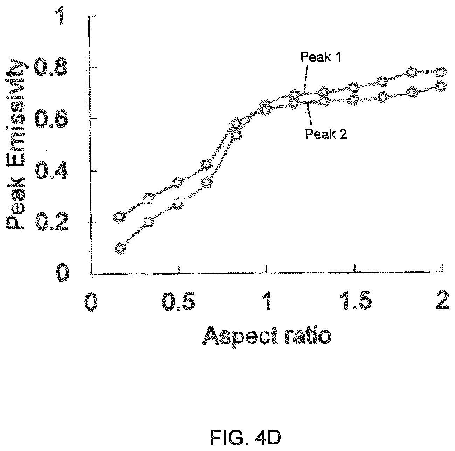

FIG. 4D is a graph showing peak emissivity for nanostructures formed from silicon nitride and having aspect ratios between about 0.1 and 2.0 according to the subject matter disclosed herein. A first peak (Peak 1) of emissivity may be observed at about 10000 nm, and a second peak (Peak 2) of emissivity may be observed at about 12500 nm. The emissivity Peak 1 and emissivity Peak 2 respectively correspond to Trough 1 and Trough 2 in FIG. 4B. As the ARs increase from about 0.14 to 2.0, the emissivity correspondingly increases at the two emissivity peaks. Although not shown in FIG. 4D, when the AR is about 1.0, the emissivity is greater than about 60% for wavelengths between about 9500 nm and about 13000 nm inclusive.

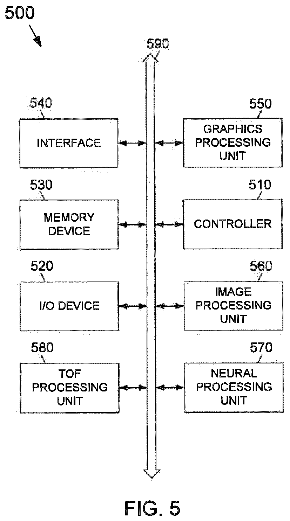

FIG. 5 depicts an electronic device 500 that may be configured to provide a non-contact thermal sensor that includes a thermal-nanostructured metamaterial configured to be a thermal coating, window, or lens, according to the subject matter disclosed herein. Electronic device 500 and the various system components of electronic device 500 may be formed from one or modules. The electronic device 500 may include a controller (or CPU) 510, an input/output device 520 such as, but not limited to, a keypad, a keyboard, a display, a touch-screen display, a 2D image sensor, a 3D image sensor, a memory 530, an interface 540, a GPU 550, an imaging-processing unit 560, a neural processing unit 570, a TOF processing unit 580 that are coupled to each other through a bus 590. In one embodiment, the 2D image sensor, the 3D image sensor and/or the non-contact thermal sensor may be part of the imaging processing unit 560. The controller 510 may include, for example, at least one microprocessor, at least one digital signal processor, at least one microcontroller, or the like. The memory 530 may be configured to store a command code to be used by the controller 510 and/or to store a user data. In another embodiment, one or more components forming the electronic device 500 may include a thermal-radiating structure according to the subject matter disclosed herein.

The interface 540 may be configured to include a wireless interface that is configured to transmit data to or receive data from, for example, a wireless communication network using a RF signal. The wireless interface 540 may include, for example, an antenna. The electronic device 500 also may be used in a communication interface protocol of a communication system, such as, but not limited to, Code Division Multiple Access (CDMA), Global System for Mobile Communications (GSM), North American Digital Communications (NADC), Extended Time Division Multiple Access (E-TDMA), Wideband CDMA (WCDMA), CDMA2000, Wi-Fi, Municipal Wi-Fi (Muni Wi-Fi), Bluetooth, Digital Enhanced Cordless Telecommunications (DECT), Wireless Universal Serial Bus (Wireless USB), Fast low-latency access with seamless handoff Orthogonal Frequency Division Multiplexing (Flash-OFDM), IEEE 802.20, General Packet Radio Service (GPRS), iBurst, Wireless Broadband (WiBro), WiMAX, WiMAX-Advanced, Universal Mobile Telecommunication Service - Time Division Duplex (UMTS-TDD), High Speed Packet Access (HSPA), Evolution Data Optimized (EVDO), Long Term Evolution - Advanced (LTE-Advanced), Multichannel Multipoint Distribution Service (MMDS), Fifth-Generation Wireless (5G), Sixth-Generation Wireless (6G), and so forth.

Embodiments of the subject matter and the operations described in this specification may be implemented in digital electronic circuitry, or in computer software, firmware, or hardware, including the structures disclosed in this specification and their structural equivalents, or in combinations of one or more of them. Embodiments of the subject matter described in this specification may be implemented as one or more computer programs, i.e., one or more modules of computer-program instructions, encoded on computer-storage medium for execution by, or to control the operation of data-processing apparatus. Alternatively or additionally, the program instructions can be encoded on an artificially-generated propagated signal, e.g., a machine-generated electrical, optical, or electromagnetic signal, which is generated to encode information for transmission to suitable receiver apparatus for execution by a data processing apparatus. A computer-storage medium can be, or be included in, a computer-readable storage device, a computer-readable storage substrate, a random or serial-access memory array or device, or a combination thereof. Moreover, while a computer-storage medium is not a propagated signal, a computer-storage medium may be a source or destination of computer-program instructions encoded in an artificially-generated propagated signal. The computer-storage medium can also be, or be included in, one or more separate physical components or media (e.g., multiple CDs, disks, or other storage devices). Additionally, the operations described in this specification may be implemented as operations performed by a data-processing apparatus on data stored on one or more computer-readable storage devices or received from other sources.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

As will be recognized by those skilled in the art, the innovative concepts described herein may be modified and varied over a wide range of applications. Accordingly, the scope of claimed subject matter should not be limited to any of the specific exemplary teachings discussed above, but is instead defined by the following claims.

## Claims

1. A thermal-coating structure, comprising:
a substrate (101) comprising a top surface (102) and a bottom surface (104); and
nanostructures (100, 100') formed on and in contact with at least the top surface (102) of the substrate (101), the nanostructures (100, 100') comprising a refractive index of less than or equal to 1.75, the nanostructures (100, 100') being substantially uniformly distributed across a first predetermined area of at least the top surface (102) of the substrate (101), and a number of the nanostructures (100, 100') further comprising a nominal aspect ratio (AR) of a structure height (h) to a structure width (d) greater than or equal to 1, wherein the nanostructures are further substantially uniformly distributed across a second predetermined area of the bottom surface (104) of the substrate (101),
wherein the nanostructures comprise polydimethylsiloxane, PDMS, and
wherein a number of the nanostructures (100, 100') comprise nominal aspect ratios (AR) of between 4 and 6.

2. The thermal-coating structure of claim 1, wherein the thermal-coating structure comprises a transmissivity of greater than 80% for electromagnetic radiation comprising a wavelength range of 8000 nm to 12,000 nm inclusive.

3. The thermal-coating structure of claim 1 or 2, wherein a number of the nanostructures (100, 100') comprise a nominal aspect ratio (AR) of 5.

4. The thermal-coating structure of claim 3, wherein the thermal-coating structure comprises a transmissivity of greater than 90% for electromagnetic radiation comprising a wavelength of 10,000 nm.

5. The thermal-coating structure of claim 3, wherein the thermal-coating structure comprises a transmissivity of greater than 80% for electromagnetic radiation comprising a wavelength between 2000 nm and 14,000 nm inclusive.

6. A non-contact temperature sensing device comprising the thermal-coating structure of claim 1.

## Patentansprüche

1. Eine thermische Beschichtungsstruktur, umfassend:
ein Substrat (101) mit einer Oberseite (102) und einer Unterseite (104); und
Nanostrukturen (100, 100'), die auf mindestens der Oberseite (102) des Substrats (101) ausgebildet sind und mit dieser in Kontakt sind, wobei die Nanostrukturen (100, 100') einen Brechungsindex von weniger als oder gleich 1,75 aufweisen, wobei die Nanostrukturen (100, 100') im Wesentlichen gleichmäßig über einen ersten vorbestimmten Bereich von mindestens der Oberseite (102) des Substrats (101) verteilt sind, und wobei eine Anzahl der Nanostrukturen (100, 100') ferner ein nominales Aspektverhältnis (AR) einer Strukturhöhe (h) zu einer Strukturbreite (d) von größer oder gleich 1 aufweist, wobei die Nanostrukturen ferner im Wesentlichen gleichmäßig über einen zweiten vorbestimmten Bereich der Unterseite (104) des Substrats (101) verteilt sind,
wobei die Nanostrukturen Polydimethylsiloxan, PDMS, umfassen, und
wobei eine Anzahl der Nanostrukturen (100, 100') nominale Aspektverhältnisse (AR) zwischen 4 und 6 aufweisen.

2. Die thermische Beschichtungsstruktur nach Anspruch 1, wobei die thermische Beschichtungsstruktur eine Durchlässigkeit von mehr als 80 % für elektromagnetische Strahlung mit einem Wellenlängenbereich von 8000 nm bis einschließlich 12000 nm aufweist.

3. Die thermische Beschichtungsstruktur nach Anspruch 1 oder 2, wobei eine Anzahl der Nanostrukturen (100, 100') ein nominales Aspektverhältnis (AR) von 5 aufweisen.

4. Die thermische Beschichtungsstruktur nach Anspruch 3, wobei die thermische Beschichtungsstruktur eine Durchlässigkeit von mehr als 90 % für elektromagnetische Strahlung mit einer Wellenlänge von 10000 nm aufweist.

5. Die thermische Beschichtungsstruktur nach Anspruch 3, wobei die thermische Beschichtungsstruktur eine Durchlässigkeit von mehr als 80 % für elektromagnetische Strahlung mit einer Wellenlänge zwischen 2000 nm und einschließlich 14000 nm aufweist.

6. Eine berührungslose Temperaturmessvorrichtung, welche die thermische Beschichtungsstruktur gemäß Anspruch 1 umfasst.

## Revendications

1. Structure de revêtement thermique, comprenant :
un substrat (101) présentant une surface supérieure (102) et une surface inférieure (104) ; et
des nanostructures (100, 100') formées sur au moins la surface supérieure (102) du substrat (101) et en contact avec celle-ci, lesdites nanostructures (100, 100') présentant un indice de réfraction inférieur ou égal à 1,75, lesdites nanostructures (100, 100') étant sensiblement uniformément réparties sur une première zone prédéterminée d'au moins la surface supérieure (102) du substrat (101), et un certain nombre desdites nanostructures (100, 100') présentant en outre un rapport d'aspect (AR) nominal, défini comme le rapport de la hauteur (h) de la structure à sa largeur (d), supérieur ou égal à 1,
lesdites nanostructures étant en outre sensiblement uniformément réparties sur une deuxième zone prédéterminée de la surface inférieure (104) du substrat (101),
lesdites nanostructures comprenant du polydiméthylsiloxane (PDMS), et
un certain nombre desdites nanostructures (100, 100') présentant des rapports d'aspect nominaux (AR) compris entre 4 et 6.

2. Structure de revêtement thermique selon la revendication 1, dans laquelle la structure de revêtement thermique présente une transmissivité supérieure à 80 % pour un rayonnement électromagnétique dont la plage de longueurs d'onde est comprise entre 8000 nm et 12 000 nm inclus.

3. Structure de revêtement thermique selon la revendication 1 ou 2, dans laquelle un certain nombre desdites nanostructures (100, 100') présentent un rapport d'aspect nominal (AR) égal à 5.

4. Structure de revêtement thermique selon la revendication 3, dans laquelle la structure de revêtement thermique présente une transmissivité supérieure à 90 % pour un rayonnement électromagnétique de longueur d'onde égale à 10 000 nm.

5. Structure de revêtement thermique selon la revendication 3, dans laquelle la structure de revêtement thermique présente une transmissivité supérieure à 80 % pour un rayonnement électromagnétique de longueur d'onde comprise entre 2000 nm et 14 000 nm inclus.

6. Dispositif de mesure de température sans contact, comprenant la structure de revêtement thermique selon la revendication 1.
